Europäisches Patentamt

European Patent Office

Office européen des brevets

(19)

(11) Publication number: **0 361 942**
**A2**

# (12) EUROPEAN PATENT APPLICATION

(21) Application number: **89309933.3**

(51) Int. Cl.5: **G01N 24/08 , G01N 27/26**

(22) Date of filing: **29.09.89**

(30) Priority: **30.09.88 GB 8822988**

(43) Date of publication of application:
**04.04.90 Bulletin 90/14**

(84) Designated Contracting States:
**DE FR GB IT NL**

(71) Applicant: **Kent Scientific and Industrial**
**Projects Limited**
**Physics Laboratory University of Kent**
**Canterbury Kent CT2 7NR(GB)**

(72) Inventor: **Strange, John Harvey**
**Hillmead St Stephens**
**Canterbury Kent(GB)**
Inventor: **Smith, Edward George**
**55 Hillfiedl Drive**
**Heswall Merseyside(GB)**
Inventor: **Coveney, Frank Michael**
**39 The Street Kingston**
**Nr Canterbury Kent(GB)**

(74) Representative: **Froud, Clive et al**
**ELKINGTON AND FIFE Beacon House 113**
**Kingsway**
**London WC2B 6PP(GB)**

(54) **NMR apparatus and method for electrophoretic mobility.**

(57) A NMR apparatus comprising a sample cell within a rf coil in a magnetic field, the coil being connected to a rf generator and a rf receiver, characterised in that it comprises means to provide a variable DC electric field across a sample in the sample cell and means to provide timed reversal of that field determined by the operation of the apparatus is disclosed, as is a NMR sample cell comprising a closable container characterised in that it comprises means to provide a variable DC electric field across a contained sample.

Such an apparatus or cell may be used in a method for determining electrophoretic mobility of one or more components of a sample characterised in that it comprises determining the phase shift and/or the distribution of phase shifts of an NMR signal with and without a DC electric field applied across the sample.

EP 0 361 942 A2

# NMR APPARATUS AND METHOD FOR ELECTROPHORETIC MOBILITY

This invention relates to an NMR (nuclear magnetic resonance) apparatus and method for electrophoretic mobility; more particularly, it relates to a probe arrangement and sample cell for use in conjunction with an NMR spectrometer for the measurement of ionic mobility.

One object of the present invention is to combine NMR and electrophoresis techniques to provide a method for measuring the electrophoretic mobility of small, charged molecular aggregates, in particular surfactant micelles. Such measurements provide information relating to the zeta-potential and charge of such particles.

Conventional electrophoresis techniques rely on optical monitoring of particle velocity through a microscope or, if the particles are too small to be seen, i.e $< 1\mu m$, on tagging the particle in some way, e.g with radio-active or dye tracers. These may, however, seriously affect the characteristics of the particle. The possibility of using NMR to measure flow rates has been the subject of several studies. In particular, it has been shown that the slow velocities of ions moving in electric fields of, typically, 10 $Vcm^{-1}$ may be detected by NMR. It was thought, therefore, that NMR could be used as a non-invasive method for measuring the flow of invisible species, such as surfactant micelles, in an electrophoresis experiment. Such methods have been used with some success to measure ionic velocity in simple ionic solutions, e.g $(C_2H_5)_4NBr$ in aqueous solution. (See, for example, Packer, K.J., Mol, Phys., 17, (1969), 355; Holz, M., et al, J. Magn. Reson., 69, (1986), 108; Stejskal, E.O., and Tanner, J.E., J. Chem. Phys., 42, (1965), 288; and Stejskal, E.O., Adv. Mol. Relaxation Processes, 3, (1972), 27.)

The present invention provides a NMR apparatus comprising a sample cell within a rf coil in a magnetic field, the coil being connected to a rf generator and a rf receiver, characterised in that it comprises means to provide a variable DC electric field across a samplein the sample cell and means to provide timed reversal of that field determined by the operation of the apparatus.

The present invention also provides a NMR sample cell comprising a closable container characterised in that it comprises means to provide a variable DC electric field across a contained sample.

The present invention further provides an electronic control means for use in association with such an NMR apparatus characterised in that it comprises means to provide timed reversal of a DC electric field applied to a sample determined by the operation of the apparatus.

Generally, the DC leads are rf shielded and filtered and are preferably provided with blacked platinum electrodes. A glass cell lining is advantageous.

Applications of the present invention include mobility measurement of liquid and solid systems, anionic, cationic and multicomponent systems with several ionic species.

As regards the use of the present system, the present invention provides a method for determining electrophoretic mobility of one or more components of a sample characterised in that it comprises determining the phase shift and/or the distribution of phase shifts of an NMR signal with and without a DC electiric field applied across the sample. Such determinations may be effected in the time domain or in the frequency domain, optionally separately in the case of a multicomponent sample.

In general terms, an NMR probe and sample cell arrangement is described herein which has been designed for measurement of ionic mobility in an applied electric field. The present design reduces electro-osmosis, polarization, joule heating and associated convection and frothing effects which may interfere with mobility measurement. For example, the present technique has been used for charged colloidal systems which foam seriously if electric currents are passed.

NMR spectrometers fitted with magnetic field gradient coils are known to be capable of measuring the flow of liquids using a spin echo method. The movement of charged particles in solution under the influence of an applied electric field may be measured by its effect on a spin echo or spin echoes in a pulsed NMR experiment and this provides a means of measuring electrophoretic mobility. Joule heating, electrolysis and polarization effects with associated bubbling and frothing of the sample may interfere with such measurements.

According to the present invention, an NMR probe with additional leads and a sample cell is provided, together with an electronic control system, which switches on the electric field for the short period of the NMR experiment and then reverses this field for an equal period and at equal field strength in order to cancel out accumulating electrolysis and polarization effects caused by the first pulse.

The cell must be placed in the main magnetic field, $B_0$, and a magnetic field gradient superimposed along the generally cylindrical cell axis, co-linear with the applied electric field. The magnetic field gradient may be applied in pulsed mode or continuously or in oscillatory fashion as commonly used for self-diffusion measurements.

One embodiment of the present invention will now be exemplified with reference to the accompanying diagrams wherein:

Figure 1 illustrates a sample electrophoresis cell

Figure 2 illustrates an electronic control circuit suitable to drive the electric field applied to a sample cell as shown in Figure 1

Figure 3 illustrates an electronic pulse timing diagram (with letters referring to the points on Figure 2).

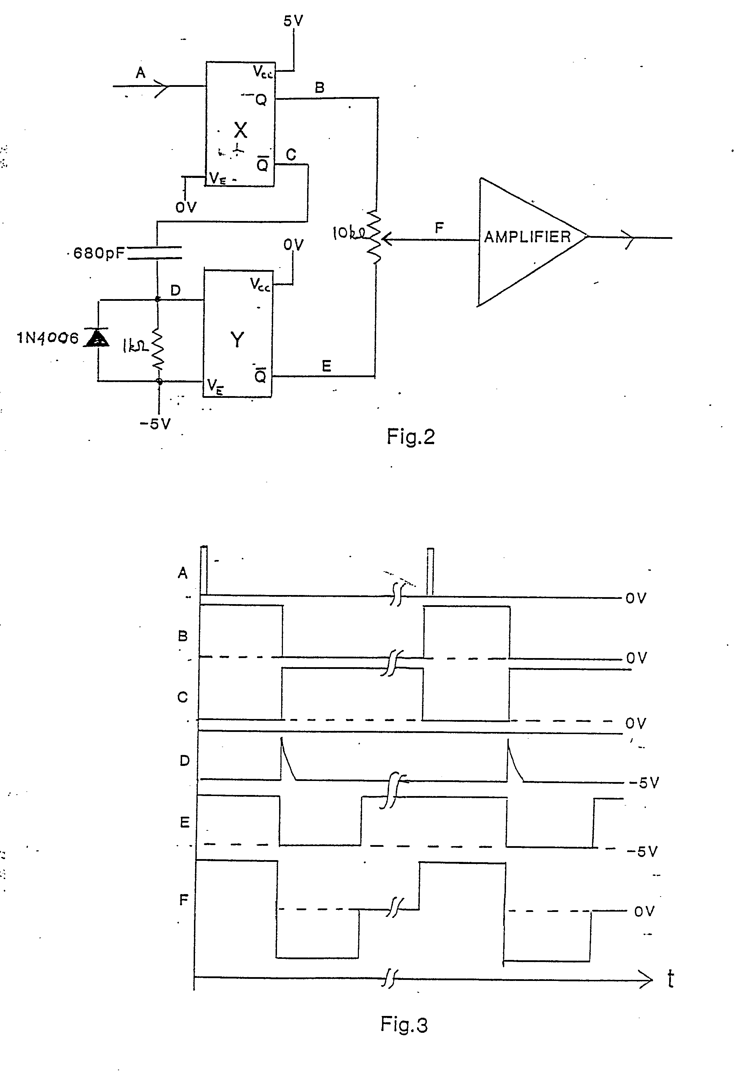

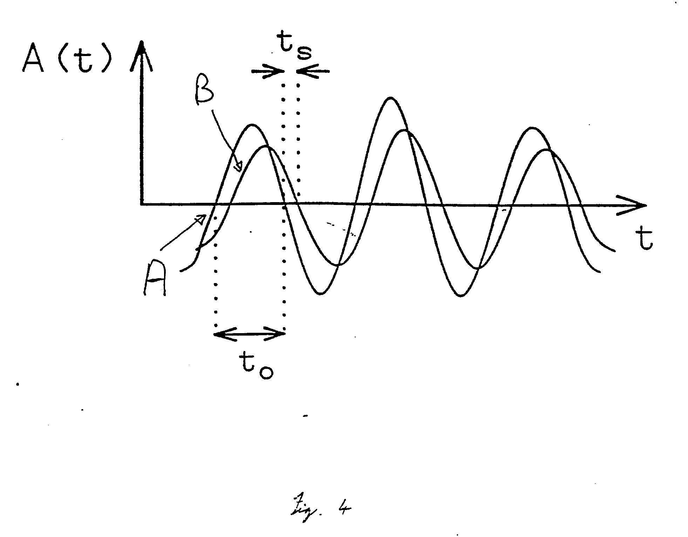

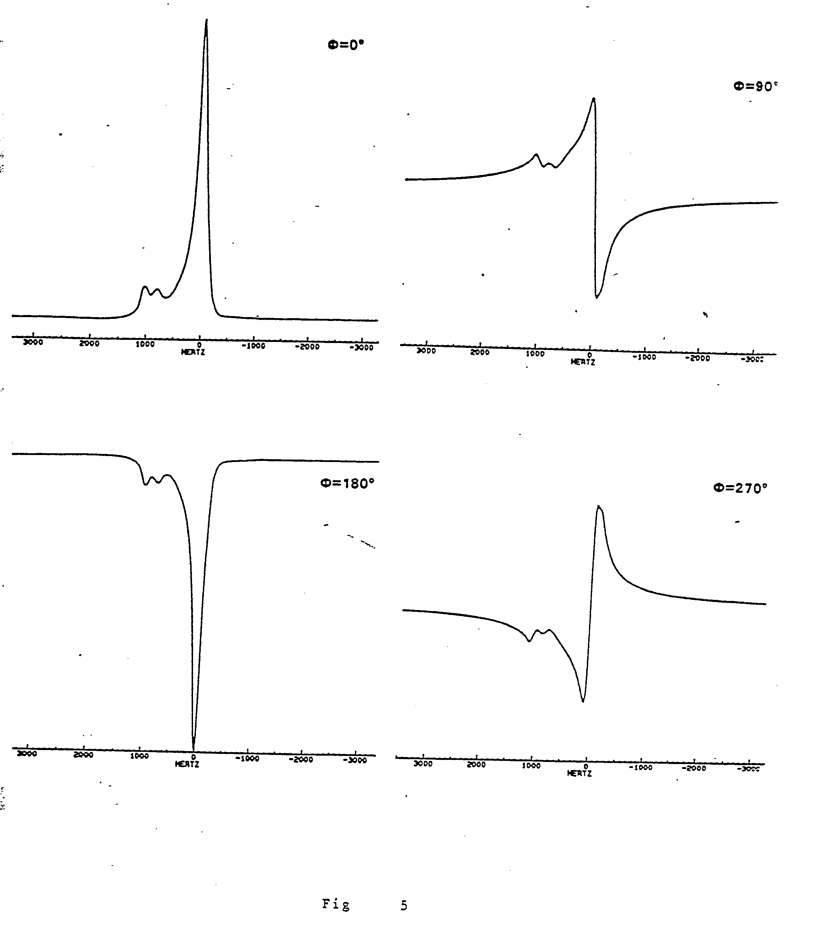

Referring to the illustrative diagram for the pulsed electric field unit, which is shown schematically in accompanying Figure 2, the pulses produced by monostables X and Y are of variable length, but have to be adjusted independently due to the different working voltages of the monostables. The 10kΩ potentiometer, across which the pulses are added, allows a balancing of the positive and negative pulses, B and E, at the amplifier input, F. The pulse sequence is triggered by the NMR spectrometer to coincide with the first rf pulse of the NMR pulse sequence. In one embodiment, the element, which may be a Tunewell PFA100, is a high voltage, high power amplifier. The pulse sequence is triggered by the rising edge of a trigger pulse (A) from an NMR spectrometer. This coincides with the first rf pulse of the NMR pulse sequence. Input A triggers monostable X producing a positive pulse of variable length from output Q (B) which forms the first half of the pulse sequence. The output from Q or $X^{(c)}$ is used to trigger Y, Q is pulled down to -5V via the 680pF capacitor and this, in conjunction with the lk resistor, produces a short pulse (D), the positive edge of which triggers Y. The 1N4006 diode in parallel eliminates another short pulse which is otherwise produced by the rising edge of C, since the RC network connected to the input of Y acts as a differentiating circuit. The Q output of Y consists of a negative pulse (E) of variable length, the start of which coincides with the end of B. This forms the second half of the electrophoretic pulse sequence. B and E are summed together across a 10k potentiometer allowing balancing of positive and negative pulses, B and E, at the amplifier input (F). This produces a single cycle of a square wave which is then amplified to high voltage, high power. The length of the positive-going electric field pulse illustrated in Figure 3 F must extend from the start of the NMR pulse sequence until after the NMR spin echo or echoes to be used to measure the ionic mobility. Alternatively, the electric field may be switched to zero during the period of spin echo observation.

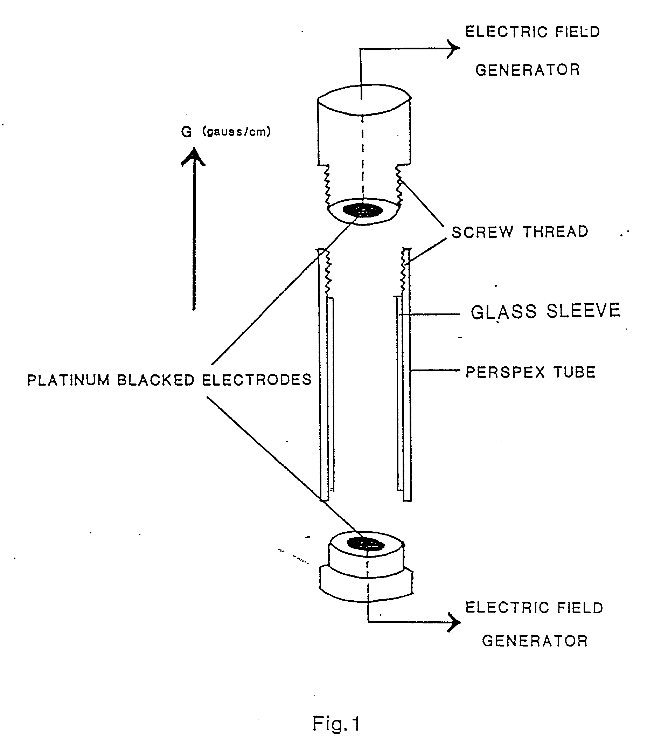

A suitable sample cell is illustrated in accompanying Figure 1. The cell is filled with the sample, e.g. liquid, under study. In one embodiment, the cell is made in "Perspex" with platinum electrodes, which are platinum blacked. To overcome electro-osmosis, a thin-walled glass sleeve may be inserted as a lining of the cell. Such a sample cell arrangement is suitable for use in axial or transverse magnetic field geometry.

For example, in some experiments the NMR field gradient coils were four rectangular loops of 10 turns of 20 swg enamelled copper wire wound on a "Perspex" former. The probe and rf shielding slides down a hole in the middle of this "Perspex" block so that no signal is received from the "Perspex". The wire loops were adhered into position using epoxy resin. It is important that the coils be kept firmly in position since any movement during an experiment causes severe echo instability. The gradient coils were designed according to earlier proposals and a high degree of linearity in field gradient is important.

In accordance with the present invention, a "conventional" NMR spectrometer will require a specialised probe, containing additional screened electrical leads, to connect the electrical supply (Figure 2) to the cell (Figure 1). These leads should contain rf filters to prevent stray signals and noise from entering the NMR receiver system.

The NMR signals may be observed by using a phase sensitive detector in the receiver and good main magnetic field stability is important. The magnet should also have a high homogeneity otherwise the spin echo may be attenuated severely by self-diffusion in the associated field gradients.

Having given a simple general introduction, the present invention will now be further illustrated and discussed with more emphasis on practical detail.

One suitable spectrometer for the present purposes is a Bruker CXP-300. This is primarily a high resolution, high power spectrometer designed for obtaining high resolution spectra for the liquid and solid states. It works at 300MHz with the advantages of good signal/noise and good chemical shift resolution due to the high operating frequency.

It does also have a custom built probe incorporating reversed Helmholtz coils ("Maxwell pair") to provide field gradients, with PFG (pulsed field gradient) pulses being provided by a Bruker ZK-300 unit. The spectrometer is controlled by an ASPECT 3000 computer enabling rapid Fourier Transform facilities and manipulation of data. The magnet associated with this spectrometer is a 7 Tesla superconducting magnet, which has certain experimental advantages, it also has a sophisticated shim coil system giving very good $B_o$ homogeneity.

Current flowing through the electrophoresis cell may be monitored by observing the potential difference produced across a 100Ω resistor placed in series with the cell on an oscilloscope. This is a particularly useful facility since there is no other way of observing effects, such as excessive frothing in the cell once it is loaded in the probe.

Another feature of this unit is that a switch was built into the circuit to enable the polarity of the voltage applied to the electrophoresis cell to be reversed easily.

An electrophoresis cell used for experimental purposes comprised a straight 8mm diameter tube milled from "Perspex" with electrodes mounted at either end. The electrodes consisted of 3mm diameter platinum discs soldered to swg 26 lacquered copper wire. The electrodes are treated by a 'blacking' process in which they are thoroughly cleaned by detergent, water, conc. nitric acid and water again. After this treatment a pair of electrodes is immersed in a 2% solution of chloroplatinic acid containing 0.02% lead acetate. A current of about 100mA is passed through this solution alternating the polarity of the electrodes at regular intervals of 30s. This treatment results in the deposition of a black film on the electrodes. This produces a very large increase in the surface area and capacitance of the electrodes. The increase in capacitance, together with the application of an appropriate square wave electric pulse, helps maintain a nearly constant electric field across the solution by increasing the RC time constant of the cell. Also the increase in surface area reduces the tendency, which is pronounced for bare platinum electrodes, for gas bubbles to be formed at the electrodes, which is a particular problem when working with surfactant systems and leads to excessive frothing. If gas is formed, $O_2$ and $H_2$, on successive polarity pulses, then the large platinum surface area helps to recombine the gas molecules catalytically. The importance of producing a reversed electric field pulse equal in length and amplitude to that applied during the spin echo sequence is apparent. Using these 'blacked' electrodes, pulses of lengths up to 100ms could be employed with electric fields of $20Vcm^{-1}$ without any problems being caused by frothing or bubbling. When current is passed through the cell filled with an electrolyte, potassium chloride, the pulses are reasonably rectangular, indicating that not much polarisation occurs over the length of the pulses. The electrodes are mounted so that they may be easily detached for cleaning or reblacking. Also, they are connected to the PEF (pulsed electric field) unit via leads which are carefully screened and filtered to prevent noise being induced in the receiver coil. The cell also has a screw-in top to facilitate the loading of sample solutions, for example.

The present invention also relates to the use of such a system, for example in connection with phase shift measurements.

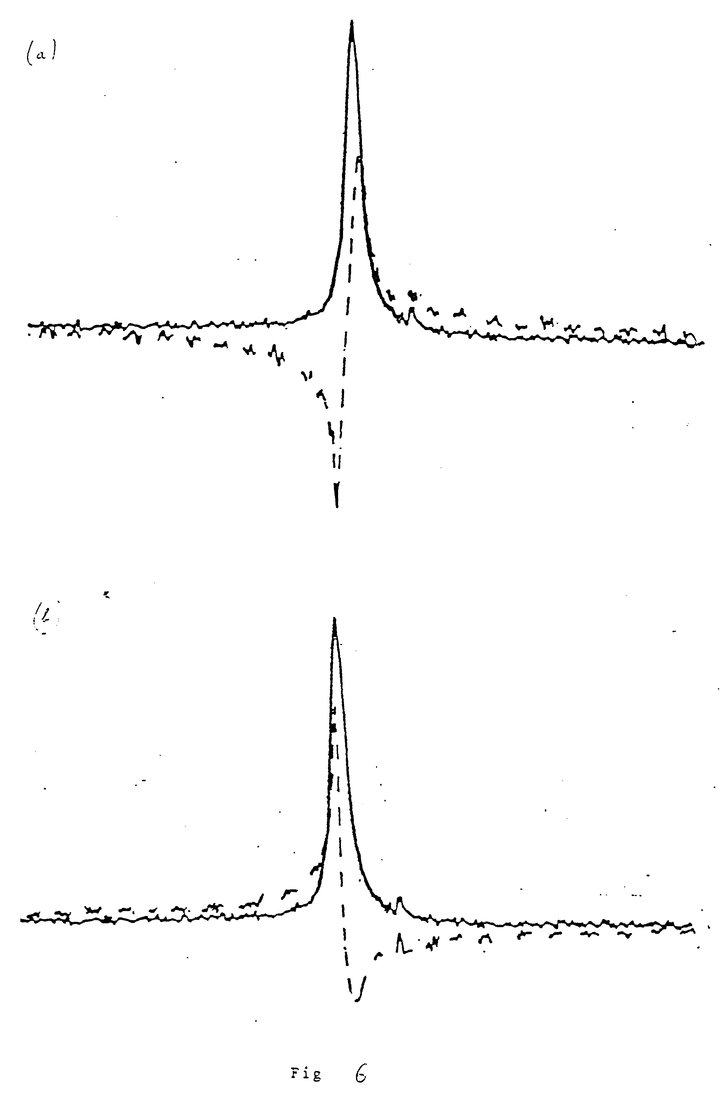

Phase shift measurements in the time domain are relatively straightforward and accompanying Figure 4 illustrates the technique used. The NMR spectrometer is set off-resonance so that a beat pattern is observed in the echo signal. The echo signal is recorded in the absence of flow, curve A, and the time interval between two zero or crossing points, $t_o$, which corresponds to an angle of $\pi$ radians is measured. The electric field is then switched on to produce flow and the echo recorded once again, curve B. The phase of the echo in the presence of flow is shifted by $\phi$ radians and this may be seen directly as a time shift, $t_s$, of the zero points of curve B along the time axis. The phase shift may then be calculated:

$$\phi = \frac{t_s}{t_o} \times \pi$$

In practise, both echo signals were captured on two channels of a storage oscilloscope and the x position of all the echo zero points was recorded and then $t_s$ and $t_o$ were worked out from this data. Such a technique is suitable for the measurement of small phase shifts.

The technique described above is well suited for spectrometers working at low frequency. However, problems arise when working at high frequencies, e.g with the Bruker CXP-300. This is because the chemical shift of nuclei is frequency-dependent, so that at a high frequency the shifts are large, i.e several hundred Hertz. This means that the FID contains chemical information corresponding to the different resonant frequencies of the chemically-shifted nuclei which produces a beat pattern on the FID. This makes it impossible to determine accurately the zero points of the echo.

In order to overcome this problem, it was decided to incorporate Fourier transform analysis into the method. This is a well-known mathematical procedure which enables resolution of the different frequencies contained in a time domain signal in the frequency domain. In the presence of flow, each frequency peak corresponding to a nucleus contained in the flowing particle will exhibit a cosinusoidal modulation proportional to the rate of flow of the particle. The problem then is how to quantify this phase shift in the frequency domain.

Most modern commercial spectrometers, such as the CXP-300, are specifically designed for obtaining high resolution frequency spectra and are therefore easily able to resolve the different frequency peaks in samples. Also, the CXP-300 has numerous data handling routines, such as Fourier transform routines. It also has the facility to adjust the phase of spectra by going into EP mode, the phase of a spectrum may then be adjusted manually and the change in phase may be measured by recording the change in the parameter PHZ0 which is stored along with other parameters relating to the spectrum.

In order to make a phase shift measurement in the frequency spectrum, the procedure is to capture the second half of the echo, so that it appears as a normal FID, without flow, Fourier transform it, adjust the phase of the resulting spectrum so that it is all in the absorption mode, i.e all the peaks are above the baseline, and note the value of PHZ0. Then, the second half of an echo is captured in the presence of flow and is Fourier transformed using the same phase parameters as for the previous spectrum. This is done by using the PK command on the CXP-300, the resulting spectrum has peaks which are phase shifted, according to the flow of the species corresponding to the peaks. This spectrum is then also phased up into the absorption mode and the value of PHZ0 again noted. The change in PHZ0 gives the phase shift in degrees. If different peaks in a spectrum correspond to species which are in the same molecule or particle which is flowing then of course they should all be phase shifted by the same amount.

So as to test this method, a normal spectrum of sodium dodecyl sulphate (SDS) was taken, see accompanying illustrative Figure 5, and the value of PHZ0 was noted when it was in pure absorption mode. Then, the phase of the spectrum was changed by 90°, 180. and 270°. This may be done reasonably accurately because, for a 180° phase shift, the peaks are all negative, and, for 90° and 270° phase shifts, the positive and negative peak heights are equal. The PHZ0 values for these phase shifted spectra were noted and are listed below. It may be seen that the changes in the PHZ0 values correspond to the expected phase shifts and it was felt justified to use this technique to measure phase shifts in the frequency spectrum for flow experiments.

| φ of spectrum | PHZO value | change in PHZO |
|---|---|---|
| 0° | 2000 | 0 |
| 90° | 292 | 92 |
| 180° | 16 | 176 |
| 270° | 115 | 275 |

(The slight errors are due to the phase of the spectrum being set by eye.)

An accurate measurement of the electric field strength is required for the analysis of results. Due to interactions at the electrode-solution interface, the absolute value of the electric field within the solution will be lower than the potential difference applied to the cell divided by the inter-electrode distance.

The electric field was therefore calibrated in two ways for a given electrophoresis cell. The first involved inserting two platinum probes into the inter-electrode cavity and measuring the potential difference between them with an oscilloscope as the electric field was pulsed across them. The electric fields were supplied using several batteries as the power supply and so calibrations were only required for the three available field strengths corresponding to applied voltages of 18V, 27V and 36V. The inserted probes were 0.9cm apart and the results obtained were as follows:

| Battery voltage/V | P.D across probes/V | Electric field/Vcm$^{-1}$ |
|---|---|---|
| 18 | 5.0 | 5.56 |
| 27 | 7.6 | 8.43 |
| 36 | 10.1 | 11.21 |

For the second calibration method, the electrophoresis cell was filled with a solution of known electrical conductivity, K, (a 0.1M solution of KCl having a conductivity of $1.289 \times 10^{-2} \Omega^{-1} cm^{-1}$ was used), and the electrical resistance of the cell, R, was measured on a Wayne-Kerr conductivity bridge. The effective inter-electrode distance, d, is then given by:

d = RKA

where A represents cross-sectional area of the cell.

The internal diameter of the particular cell was 0.4 cm so with A = 0.126 cm$^2$ and R measured as 1975$\Omega$, a value of 3.21cm was obtained for d, which is slightly larger than the actual value of 3.1 cm. The effective electric field is now simply the potential difference applied to the cell divided by d, which once again is given for the three battery voltages available

| Battery voltage/V | Electric field/Vcm$^{-1}$ |
|---|---|
| 18 | 5.60 |
| 27 | 8.41 |
| 36 | 11.21 |

As may be seen, these results agree very well with those obtained from the first method of calibration.

By way of further illustration, such electrophoresis measurements have been performed on a surfactant system, the bulk properties of which are of particular interest to the detergent and soap industry. In solution, surfactant molecules form molecular aggregates termed "micelles", which are often electronically charged and flow under the influence of an electric field. Two types of surfactant were used, both of which were apparently well-known systems supplied by Unilever. These were SDS, an anionic surfactant, and cetyl trimethylammonium bromide (CTAB), a cationic surfactant. Solutions thereof were prepared in 99.7% pure deuterium oxide, obtained from Aldrich. $D_2O$ was used to avoid the very large background proton signal that would have been given had the samples been made in $H_2O$.

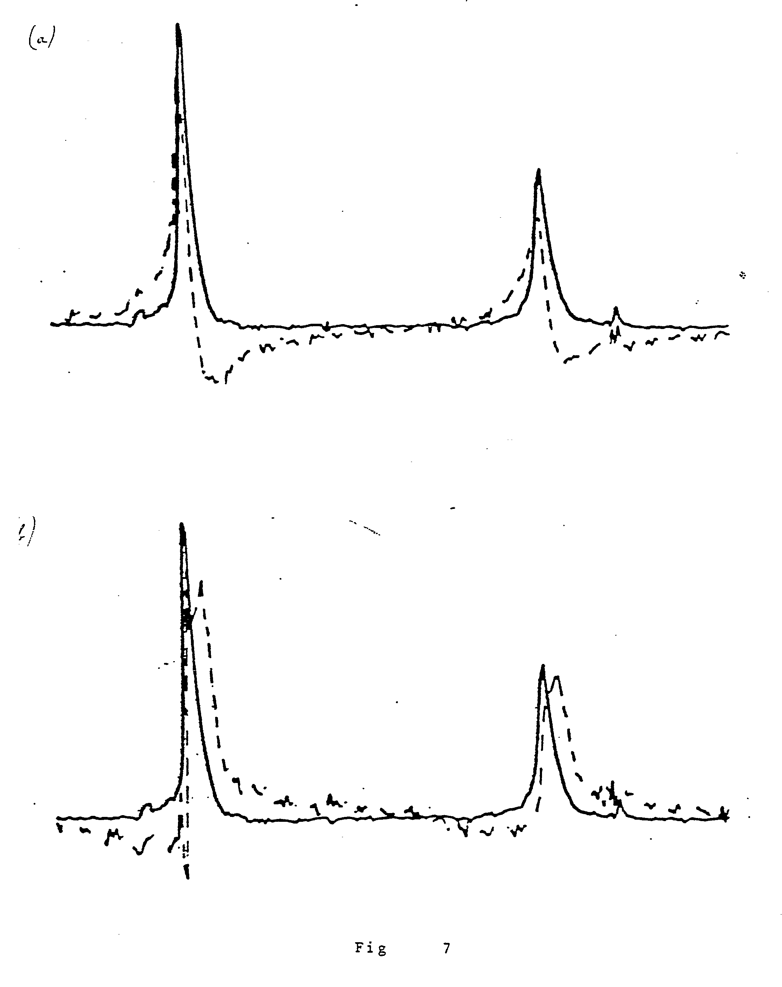

Accompanying illustrative Figures 6 and 7 present some CXP-300 results from experiments performed to observe phase shifts, due to flow of micelles, in the frequency domain. The samples used were SDS and CTAB in $D_2O$, both at a concentration of 5%, by weight. The phase shifts may be clearly seen and were measured by means already described.

The phase shifts measured in these experiments were relatively large, 25$^\circ$ and 25$^\circ$ for SDS and 30$^\circ$ and 30$^\circ$ for CTAB, such phase shifts were obtained by using high electric fields, 11.5 Vcm$^{-1}$. The use of higher electric fields caused additional attenuation of the echo and consequently signal/noise suffered. This is not immediately clear from the Figures because the printing routine of the spectrometer scales all traces to the same size, however close inspection of the Figures reveals an increased amount of noise on the spectra with applied electric field. The method used for quantifying the phase shifts works equally well for smaller phase shifts and so there is no particular advantage in increasing the electric fields to produce such phase shifts for routine experiments at the expense of signal/noise. It may be argued that measuring larger phase shifts would make the percentage errors smaller, however, with the decreased signal/noise factor, it is harder to set the PHZ0 parameter accurately.

Both the peaks in the spectra for experiments with CTAB are phase shifted by the same amount, within the experimental error. This is an important point since both peaks correspond to protons within the same surfactant micelle and must therefore be moving at the same velocity.

Both Figures show that the effect of reversing the polarity of the applied electric field is a corresponding reversal of the phase shift. This is a direct verification that the observed phase shift is due to electrophoretic flow of micelles.

Comparison of Figure 6(a) with Figure 7(a) and 6(b) with 7(b) reveals that the phase shifts of these pairs of spectra are mutually reversed and this shows that the anionic and cationic surfactant micelles flow in opposite directions, as would be expected. (Care was taken when changing samples to keep the electric field polarity the same in order to be able to demonstrate this point.)

Figure 7 (b) shows most clearly that the NMR lineshapes have changed with the application of the electric field, in particular they are broader. This effect is consistent with the application of a small field gradient to the sample or a decrease in $T_2$. There is no apparent reason why the application of an electric field to a sample should shorten the spin-spin relaxation of the sample. The only possible source of an applied field gradient would be internally generated field gradients, but with this experimental set-up there should be no z-component of such field gradients. However, it is not entirely possible to rule out a small effect from internal field gradients if the central axis of the cell is not exactly collinear with the main $B_z$ field. The broadening of the lines could also be due to an apparent frequency shift across the echo. Such a shift would imply that a spread of frequency components is contained within the signal and underlines the advantage of switching the electric field off during the echo acquisition.

As mentioned above, it was initially decided to use deuterium oxide rather than pure water as the surfactant solvent in order the avoid the large proton signal that would be produced by water. However, it became clear that this was not absolutely necessary for NMR/electrophoresis experiments. The reason for this is that the signal from water protons is so severely attenuated by the process of self-diffusion, i.e because water molecules have a relatively high self-diffusion coefficient. For example, with typical values for G, and $\delta$ of 0.08Tm$^{-1}$, 40ms and 8ms, respectively, and using a value for $D_{self}$ of 2. 4x10$^{-9}$m$^2$s$^{-1}$, there was obtained an attenuation in echo amplitude of 93%. For time domain measurements therefore, the signal from water would contribute virtually nothing to the echo signal. In the frequency domain, of course, the peak corresponding to water is separated from the surfactant peak by chemical shift.

In order to see the effect of using water as the solvent instead of D$_2$O, the following experiment was performed: A sample of CTAB at 5%, by weight, was made up in pure water. With the experimental parameters described above, a normal high resolution flow experiment was carried out, i.e spectra were captured with and without applied electric field and compared.

It was hoped that phase shifts would be observed in the peaks corresponding to the surfactant and none in the water peak. It was found that to be able to retain a visible water peak after attenuation from diffusion it was necessary to keep the value of $\delta$ small, i.e 8ms, which leads to a small phase shift due to flow. The phase shift was detectable however, while the water peak is not phase shifted at all. An additional attenuation due to non-uniform flow was observed, however, although once again this is not clear due to the scaling of the traces inside the spectrometer.

Apart from demonstrating that the use of D$_2$O as a solvent is not necessarily required, this experiment also demonstrates the usefulness of the high resolution technique to differentiate between the behaviour of different components within a sample.

Having observed phase shifts in the time and frequency domains and measured the expected linear dependence of the phase shifts on field gradient width, it was decided to try and detect the variation of phase shift and flow measurements with two other experimental parameters as a further check that the effects seen were due solely to the flow of charged micelles. The experimental parameters chosen were field gradient strength, G, and electric field strength, E. Phase shift, $\phi$, due to flow depends linearly on both these factors.

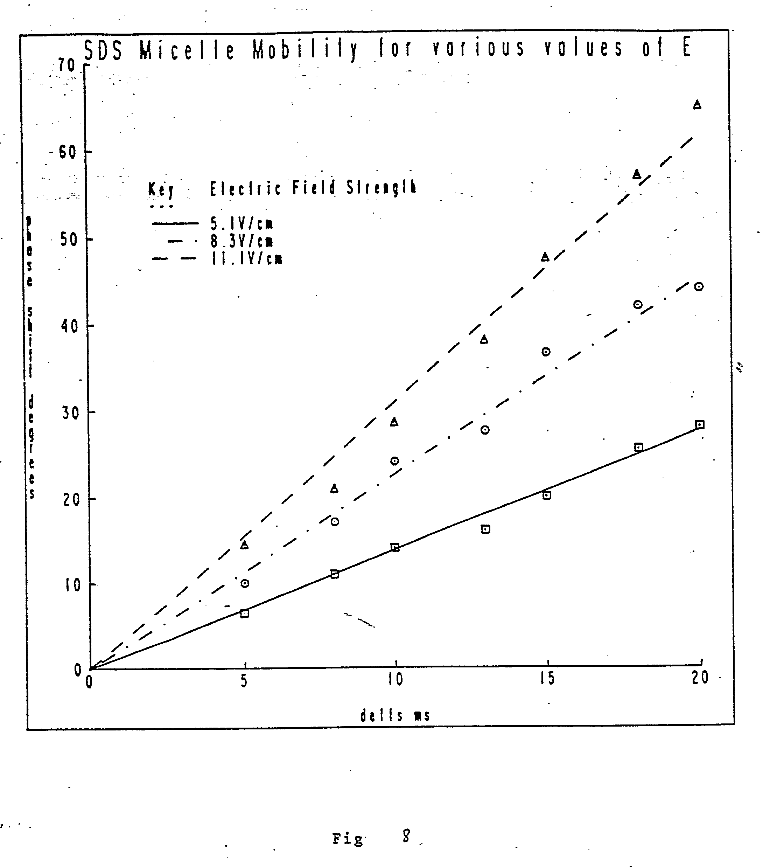

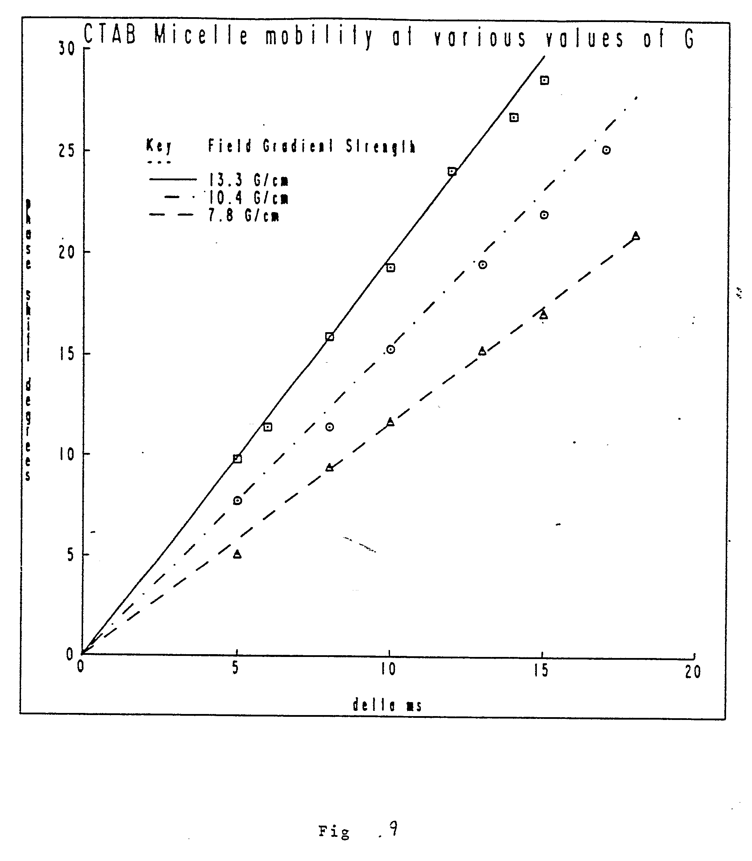

In each case, different values of G and E were set and the variation of $\phi$ with $\delta$ recorded. The experiments with variation of G were performed with a sample of SDS in D$_2$O at 5%, by weight, using the off-resonance spin echo technique. The variation of $\phi$ with E was investigated also with a sample of 5% SDS. The three graphs obtained from these two experiments are illustrated in Figures 8 and 9. As may be seen from the graphs, there is a good linear relationship between $\phi$ and $\delta$ in all cases.

## Claims

1. A NMR apparatus comprising a sample cell within a rf coil in a magnetic field, the coil being connected to a rf generator and a rf receiver, characterised in that it comprises means to provide a variable DC electric field across a sample in the sample cell and means to provide timed reversal of that field determined by the operation of the apparatus.

2. A NMR sample cell comprising a closable container characterised in that it comprises means to provide a variable DC electric field across a contained sample.

3. An apparatus as claimed in claim 1 or a cell as claimed in claim 2 wherein the DC field provision means comprises rf shielded and filtered leads.

4. An apparatus as claimed in claim 1 or claim 3 or a cell as claimed in claim 2 or claim 3 wherein the DC field provision means comprises blacked platinum electrodes.

5. An apparatus as claimed in any of claims 1,3 or 4 or a cell as claimed in any of claims 2 to 4 wherein a glass cell lining is provided.

6. A method for determining electrophoretic mobility of one or more components of a sample characterised in that it comprises determining the phase shift and/or the distribution of phase shifts of an NMR signal with and without a DC electric field applied across the sample using a NMR apparatus as claimed in any of claims 1 or 3 to 5 or a cell as claimed in any of claims 2 to 5.

7. A method as claimed in claim 6 wherein the determination is effected in the time domain.

8. A method as claimed in claim 6 wherein the determination is effected in the frequency domain, optionally separately in the case of a multicomponent sample.

9. A method as claimed in any of claims 6 to 8 wherein current through the sample cell is monitored simultaneously.

10. An electronic control means for use in association with a NMR apparatus as defined in claim 1 characterised in that it comprises means to provide timed reversal of a DC electric field applied to a sample determined by the operation of the apparatus.

Fig. 1

Fig.2

Fig.3

Fig. 4

Fig    5

(a)

(b)

Fig 6

(a)

(b)

Fig    7

Fig 8

Fig .9